# EUROPEAN PATENT SPECIFICATION

(11) **EP 1 305 643 B1**
(45) Date of publication and mention of the grant of the patent: **09.11.2005**
(21) Application number: 01953231.6
(22) Date of filing: 31.07.2001
(51) Int. Cl.: G01R 1/067, G01R 1/44

(54) **SIGNAL MEASUREMENT**
SIGNALMESSUNG
MESURE D'UN SIGNAL

(30) Priority: 31.07.2000 GB 0018762
(43) Date of publication of application: 02.05.2003
(73) Proprietor: IFR Limited, Stevenage, Hertfordshire SG1 2BA (GB)
(72) Inventor: OWEN, David, Paul, Dunstable, Bedfordshire LU5 4SH (GB); WELLS, John, Norman, St Albans, Hertfordshire AL4 9UU (GB)
(74) Representative: Gillard, Matthew Paul
(86) International application number: PCT/GB2001/003420
(87) International publication number: WO 2002/010776

(56) References cited:
- EP-A- 0 548 844
- US-A- 4 472 685
- US-A- 4 887 313
- US-A- 5 033 289
- US-A- 5 146 171
- US-A- 5 231 349

## Description

This invention relates to apparatus and methods for measuring parameters of wireless signals.

In radio communications systems, the measurement of a transmitter is important and transmitter parameters have to be checked in the design and the manufacture of a transmitter. Manufacturers typically need to measure the performance of the transmitter with accuracy of the order of 0.1 dB to minimise the stand-off between the measured performance and the guaranteed performance.

Transmitters also need to be measured for imperfections in their output These imperfections include modulation accuracy (depth, deviation or Error Vector Magnitude (EVM)) and spurious emissions (adjacent channel power, spurious signals, and wide band noise).

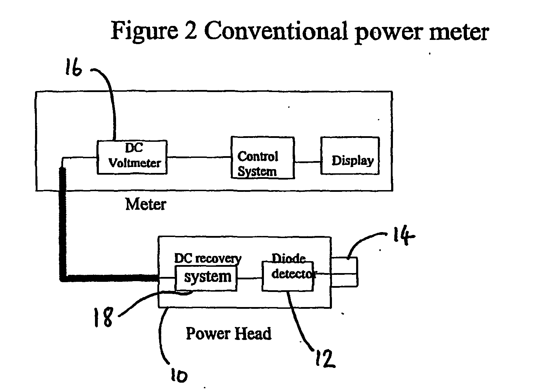

Power measurements are typically performed using dedicated power meters, such as the IFR 6960. As shown in Figure 2, these devices use a power head 10 that includes a diode detector 12 operated in its power (square) law region. Power applied to the power head via test input 14 is detected as a low frequency (or DC) signal at the output of the diode detector and this signal is measured by a DC voltmeter arrangement 16. The detected signal level is typically very low, so to measure low signal powers the DC voltmeter has to be very sensitive. Signal conditioning circuits 18 are used to aid the recovery of the signal.

Power meters designed for use on radio systems which have a high data rate and use modulation methods which involve the output varying rapidly as a function of time may use a sampling system to measure the output from the detector diode arrangement.

Power meters implemented in this way are in principle very simple devices, but in practice correcting for the characteristics of the diode detector can be complex. The diodes exhibit deviations from the ideal linear input power to linear output voltage characteristics that are temperature, time and frequency dependent These errors need to be accurately modelled if they are to be corrected.

This type of power meter cannot do some of the measurements associated with modem CDMA systems, such as code domain power. In these systems, the signal whose power is to be measured is accompanied by other signals which the detector cannot separate from the wanted signal.
Both these types of power meters suffer from linearity and zero input power reference problems.

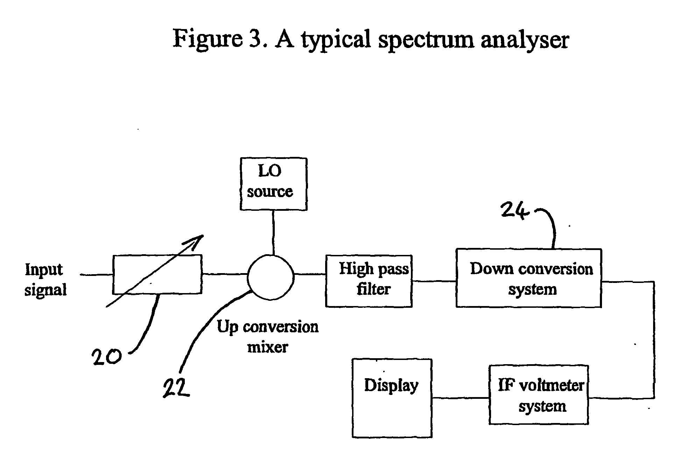

Spectrum analysers, such as the IFR 2390, can also be used to measure transmitter characteristics. These instruments, as shown in Figure 3, use a number of stages of switched input attenuation 20, frequency conversion (22, 24), including an initial up conversion stage 22, and amplification before arriving at a final intermediate frequency (IF) at which the signal is measured. The long RF or microwave chain means that the power accuracy of such instruments is limited and affected by a large number of factors.

Some improvement can be obtained by replacing the detectors in the final IF with an analogue to digital converter. This also allows some modulation measurements to be performed in addition to the spectral measurements.

Modulation analysers, such as the IFR 2310, can also perform power measurements. Such instruments again use a switched attenuation but with a simpler frequency converting front end (compared to a spectrum analyser) before measuring the signal. The power measurement accuracy is better than a spectrum analyser but not as good as a power meter.

EP-0548844-A2 discloses a system for sending a reception level indication to a satellite dish in which the indication is sent digitally but deduced in the analogue domain.

According to one aspect, the invention provides a signal power measurement system as defined in claim 1, to which reference should now be made.

The invention thus provides a power measurement system with a detector head for use at a location remote from the signal processing apparatus and which is not inhibited from performing individual power measurements on CDMA signals having the same carrier frequency.

In a preferred embodiment, the cable conveys multiple signals. For example, the cable can bring a downconverting signal to the mixing means from the signal processing apparatus. Alternatively or additionally, the cable can bring a power supply into the detector head (e.g. for a heater therein).

The detector head may contain an attenuator for reducing the level of the test signal prior to mixing. This provides that the downconverted signal has a level appropriate for the signal handling apparatus.

The detector head may include means for amplifying the downconverted signal to provide that the downconverted signal has a level appropriate for the signal handling apparatus.

The detector head may have means for controlling the environmental conditions around the mixing means. This helps to stabilise the instrument and assists with obtaining accurate measurements from the signal measuring apparatus. If an amplifier is used for the downconverted signal this too may be placed in the same or a separate controlled environment.

The aforementioned amplifier may be housed in the signal processing apparatus.

The signal processing apparatus operates on the down-converted signal in the digital domain. The signal processing apparatus may be capable of measuring any of the power, the spectrum, or the modulation of the downconverted signal, which can be related back to the corresponding parameter(s) of the test signal.

By way of example only, certain embodiments of the invention will now be described with reference to the accompanying drawings, in which:
Figure 1 is a block diagram of a system comprising an detector head and signal processing apparatus according to the invention; and
Figure 2 and 3 are block diagrams of conventional signal processing systems.

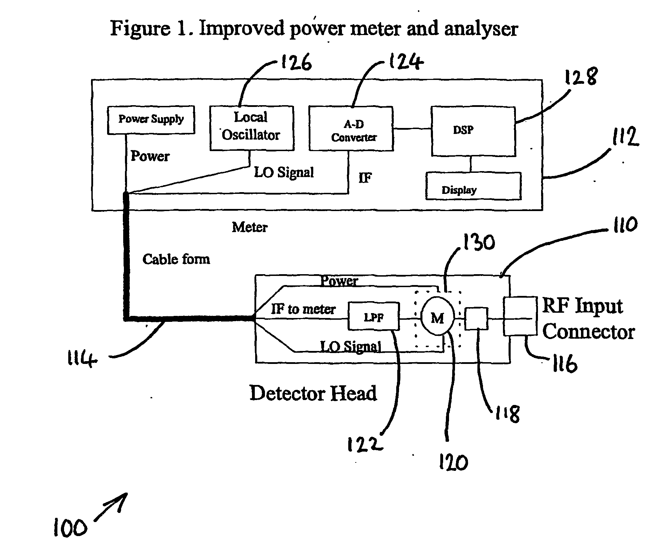

The signal measuring apparatus 100 of Figure 1 uses a detector head 110 connected to a meter 112 by a cable 114. The cable 114 allows the meter to supply power and a RF local oscillator (LO) signal to the detector head 110, and the detector head 110 to send an intermediate frequency (IF) to the meter 112.

The detector head 110 accepts the signal to be measured, typically on a type N coaxial connector 116. The signal at the connector is then attenuated using a fixed attenuator pad 118 to scale the maximum signal level to be measured down to an amplitude that can be handled by the following circuits.

The output from the attenuator (at frequency F_{IN}) is taken to a RF mixer 120. The local oscillator input (frequency F_{LO}) from the meter is supplied to the mixer. The mixer produces an output signal at frequency F_{LO} ± F_{IN}.

The higher frequency signal, F_{LO} + F_{IN}, is removed by a low pass filter 122 leaving the F_{LO} - F_{IN} (F_{IF}) component as the IF signal. If, for instance the input frequency (F_{IN}) is 1800 MHz, then the LO frequency could be 1770 MHz to produce a 30 MHz output from the mixer. The output from the low pass filter 122 is passed along the cable 114 to the meter 112. Once in the meter, the signal is converted into a digital form by an analogue to digital converter 124.

The meter 112 contains the LO 126 which supplies the LO signal to the detector head, the A-D converter 124 and a digital signal processing means 128 to analyse the IF signal.

The IF signal which is output by the filter 122 corresponds to a range of frequencies from the input signal that has been mixed down to fall within the pass-band of the filter 122. The meter performs measurements only on the range of input signal frequencies corresponding to the output of the filter 122, and in this sense the measurements performed by the meter are frequency-limited. The LO frequency can be adjusted to control which range of frequencies is represented by the output of the filter, thus allowing the meter to select the range of input signal frequencies upon which it makes measurements.

The simplest parameter that the instrument can measure is RF power. The level of the IF signal is directly proportional to the power of the RF signal applied to port 116. The power measurement needs to be corrected by taking account of the loss of the attenuator 118 and the mixer arrangement in the detector head 110. This correction factor can be derived during the manufacture of the instrument by direct measurement. The correction required is frequency dependent so it has to be measured over the full frequency range of the instrument.

The instrument initially needs to acquire the signal to be measured. This is done by sweeping the LO signal and observing all the changes in the level of the IF signal from the detector head 110. When signals are found, their frequency can be measured using the digital signal processing means 128. Knowing the frequency of the LO signal used to generate the response, the input signal frequency F_{IN} can be derived. The sum and differencing signals and harmonic sampling signals will result in multiple responses, but by focussing on the strongest responses the frequency F_{IN} can be derived. Alternatively, the frequency F_{IN} can be manually entered on the instrument, and from the knowledge of the wanted IF frequency needed, the LO frequency required can be set.

The level of the signal is measured by taking the digital data from the A-D converter and computing its root mean square (RMS), peak or average value (whichever the user wants to measure) and then applying the required correction value to account for the insertion loss (i.e., attenuation) of the detector head.

The accuracy of the power metering function can be made to be similar to that expected of a conventional power meter and significantly better than that expected of a spectrum analyser or (modulation) transmitter analyser.

The input impedance to the detector head 110 should be close to the 50 ohms impedance of typical RF systems because of the presence of the fixed attenuator 118. In this respect, it is similar to a conventional power meter head. There is none of the switches and other complex systems associated with spectrum analysers or transmitter analysers, which ensures the impedance is always the same.

Behind the attenuator 118, is a RF mixer 120 whose insertion loss is dependent on the level of the LO signal and the characteristics of the mixer diodes. The LO signal level needs to carefully controlled so that it doesn't vary with time and this requires the cable 114 to be of a good quality.

Enclosing the mixer 120 in a temperature-controlled environment 130 can reduce the mixer variability. Power from the meter 112 is used to heat up the mixer circuit to a specified temperature. A control system measures that temperature and adjusts a heater system to keep the temperature at a constant level, despite variations in the surrounding ambient temperature. In this way the variation of the insertion loss with ambient temperature is minimised. Since the volume of the mixer circuit is typically very small, keeping it at a constant temperature does not consume a great deal of power. While the temperature control circuits are stabilising the temperature of the mixer 120, the meter 112 can be arranged to warn the user that the detector head 110 is still not stabilised and so the best accuracy has not been achieved. Once the detector head 110 has warmed up, accurate power measurements can commence.

In a typical implementation, it may be desirable to make the cable 114 from the detector head 110 to the meter 112 in such a way that the meter 112 can accept a variety of detector heads, each optimised for different powers or frequencies of operation. The most significant technical requirement is to ensure that the LO signal is supplied to the detector head through a coaxial lead to avoid leakage, maintain good RF immunity and a constant LO amplitude.

The IF signal level from the mixer 120 may be too low in level to occupy the full scale of the A-D converter 124. The signal amplitude can be increased in with an IF amplifier. The amplifier gain factor, which may be IF frequency dependent, is taken into account by the calibration process. However, the gain may be environmentally dependent. In some cases it may be desirable to include the IF amplifier in the detector head 110 and control its temperature in the same environment 130 as the mixer 120, or alternatively provide a temperature controlled environment in the meter 112.

Compared to a conventional power meter, this system offers many advantages.

The instrument no longer requires the normal detector zeroing function that diode based detectors require. A conventional power meter needs to regularly monitor its output when no signal is applied so that DC detector errors are eliminated. This defect does not exist for the instrument 100 since, when no signal is applied, no IF signal appears. Essentially, the DSP system is measuring an AC signal rather than a DC signal and so is immune to these sorts of DC errors.

In addition, the instrument 100 does not exhibit the non-linearity associated with diode detectors. Linearity defects are limited to those introduced by the A-D converter 124 in the meter and any compression effects in the mixer.

The instrument 100 is also capable of making much greater dynamic range measurements. As an example, consider the case where a mixer designed to operate from a +7 dBm local oscillator is used. Such a mixer is capable of delivering up to -10 dBm at its output with only minor imperfections in its output linearity. The thermal noise at the output of the mixer will be -174 dBm/Hz. If the digital signal processing system, operates with a residual bandwidth of 1 MHz (large compared to conventional power meters) and if the noise figure of the following circuits is 6 dB and if an allowance off 3 dB is made for the mixer image response, then the instrument can resolve a signal level of the order of -105 dBm, giving a dynamic range of 95 dB - far greater than the typical 70 dB a conventional power meter is capable of.

In order to make measurements over this dynamic range, the A-D converter 124 needs to be capable of very fine resolution. When the IF signal level is very low, however, the converter 124 will not be able to resolve the IF signal with reasonable resolution. A switched gain IF amplifier could amplify the signal, but this would lead to compromises in the accuracy. The instrument would need to be corrected for each IF gain it could operate at. The resolution problem can be overcome by using other techniques.

When the signal level to the converter 124 is low, quantisation effects in the converter will prevent the digital signal processing means 128 from producing accurate measurements of power. However, a signal can be added to the input of the converter that is spectrally distinct from the signal to be measured. As an example, if the signal to be measured has an IF of 30 MHz, a signal could be added at 40 MHz which occupies, say, half the full scale of the converter. The A-D converter 124 is exercised over a significant region of its output codes and the digital signal processing means 128 can apply a computation routine which simply selects the frequency component that is to be measured (30 MHz). The added signal could be a sine wave or a modulated signal (including band-limited noise or a modulated carrier).

Since the power measurement is frequency selective, the power that is measured does not include errors induced by the presence of harmonic signals. Diode detector power meters are affected by the presence of harmonics since the harmonic power is included in the measurement. For transmitters in communications systems, only the power in the wanted carrier is useful, so harmonic power is an error in the measurement

Care needs to be taken in the design of the cable 114 between the detector head 110 and the meter 112. It has to carry a RF signal at a level adequate to drive the mixer in the detector head 110. A screened lead can be used to ensure the RF signal does not cause interference to other systems. If a radio system is being tested which uses a different transmit frequency compared to its receiver frequency (duplex operation, the difference in frequency being the duplex offset) then it is wise to avoid an IF frequency which is the same as the duplex offset. This avoids interfering with the receiver. For this reason it is convenient if the instrument is allowed to operate at a variety of IF frequencies.

The fact that the detector head 112 is remote from the meter has the advantage over spectrum analysers and modulation analysers of readily measuring the power at the wanted location in the test system. This is useful since it avoids the calibration errors introduced by cable losses and reflections at connector and cable interfaces. It also allows the use of a variety of different detectors to be designed to handle different power levels and frequencies.

The instrument can also be supplied with a precision RF source (calibration source), typically at a fixed frequency. If, for instance, a source is provided at 500 MHz on the meter with an output level of -10 dBm, then the detector head can be connected to the source and the meter checked to see that it reads -10 dBm. If it does not, the instrument can be corrected so it reads correctly. The LO signal from the meter can be varied in frequency so that the IF changes. The corrections for the IF response can then be checked. This process can be automatic.

In addition to making power measurements, the invention can be used to make modulation and spectral measurements.

The IF signal from the detector head can be filtered (e.g. digitally by digital signal processing means 128) to select a frequency range of the IF signal for subsequent analysis. Alternatively, the IF signal can be analysed using Fast Fourier Transform (FFT) techniques to calculate its spectral content. Any signals deliberately introduced to allow low level signals to be measured can be eliminated by software techniques.

One problem with making spectral measurements in this way is that image and spurious signals are generated from the mixer. Techniques such as these described in GB 2326724 are available to remove these spurious signals. The LO signal from the meter can be varied and ambiguities in the nature of the input signal are removed.

The same techniques can be used with harmonic sampling mixers. If the mixer is replaced with a harmonic sampling mixer then higher frequency signals can be measured without requiring a higher LO frequency. This makes it possible to extend frequency coverage to the microwave band without the problems of supplying a microwave signal down a co-axial lead to the detector head.

Modulation measurements can also be made using the digital signal processing means to perform similar techniques to those used in instruments such as the IFR 2310. It is possible to analyse the characteristics of signals carrying analogue (FM, AM Phase modulation) or digital (CDMA, GSM) modulation and derive a measure of the error in the modulation. Imperfect transmitters of digital modulation schemes also tend to spread energy into frequency bands immediately adjacent to the intended transmitter bandwidth, this energy being referred to as the adjacent channel power (ACP). The digital signal processing means can be used to measure this imperfection.

The frequency coverage of the instrument is controlled by a number of factors. If mixer 120 is a conventional double balanced mixer, the frequency coverage is limited by the range of the LO signal and the IF frequency used. As the required frequency to be measured is lowered, there comes a point at which significant spurious signals may be generated. For example, if an IF of 30 MHz is used the lowest usable RF input frequency may be 100 MHz. If the input frequency to be measured is lower, then the IF frequency could be lowered, so in the above example an IF of 10 MHz would allow a 33 MHz signal to be measured. The DSP means is designed to measure frequency selective power so the presence of the sum frequency from the mixer will not limit the measurement, though it may affect the dynamic range.

For even lower frequencies the LO and IF signal can be swapped, and a DC signal applied to the IF port of the mixer. The mixer then behaves as a switch and passes the RF input signal directly from the RF port of the mixer to the A-D converter at the same frequency as the RF input. By using this technique, power measurements can be performed to very low frequencies. The switching of the LO and IF connections can be performed in the detector head 110 or the meter 112.

Compared to conventional power and spectrum analysers, the instrument 100 is capable of handling RF pulse characteristics with little amplitude distortion and wide bandwidth. The higher the IF and A-D converter rate, the faster the pulse rise and fall time that can be handled. The IF that the detector head is designed to work at can be raised for applications requiring higher demodulation bandwidth, and a faster (but perhaps lower resolution) A-D converter used to capture the signal. The bandwidth of the meter means that true pulse characteristics can be captured on single shot effects - a feature not usually available on highspeed, peak-power meters relying on random sampling.

On new CDMA based communications systems there is a need to measure a parameter known as Code Domain Power. CDMA systems have a number of different signals being carried on a single RF carrier and on each of these signals a power measurement can be performed. A conventional power meter cannot do this measurement since it can resolve only the sum of all the signals. The invention described can use its digital signal processing system to measure each of the signals independently of each other by locking on to ("despreading") each of the code channels.

## Claims

1. A signal power measurement system (100) comprising a detector head (110), a cable (114) and signal processing apparatus (112), wherein the detector head comprises an input (116) for receiving a test signal to be measured and mixing means (120) for downconverting the test signal in frequency and the cable is arranged to connect the detector head to the signal processing apparatus and to convey the downconverted signal from the detector head to the signal processing apparatus and the system is **characterised in that** it further comprises converting means (124) for digitising the downconverted signal and **in that** the signal processing apparatus is arranged to operate on the digitised, downconverted signal in the digital domain to perform a power measurement on the test signal.

2. A system according to claim 1, wherein the cable is arranged to convey multiple signals.

3. A system according to claim 1 or 2, wherein the cable is arranged to bring a downconverting signal to the mixing means from the signal processing apparatus for mixing with the test signal to downconvert the test signal in frequency.

4. A system according to claim 1, 2 or 3, wherein the cable is arranged to bring a power supply into the detector head.

5. A system according to any one of claims 1 to 4, wherein the detector head further comprises an attenuator (118) for reducing the level of the test signal prior to mixing.

6. A system according to any one of claims 1 to 5, further comprising means for amplifying the downconverted signal to provide that the downconverted signal has a level appropriate for the signal processing apparatus.

7. A system according to claim 6, further comprising means for controlling the environmental conditions around the amplifying means.

8. A system according to any one of claims 1 to 7, wherein the detector head further comprises means for controlling the environmental conditions around the mixing means.

9. A system according to any one of claims 1 to 8, wherein the signal processing apparatus is arranged to perform a measurement of the power in the test signal attributable to a selected CDMA code.

10. A system according to any one of claims 1 to 9, wherein the signal processing apparatus is arranged to perform a measurement on a selected frequency or selected range of frequencies from the test signal.

11. A system according to claim 10, wherein the signal processing apparatus is arranged to control the mixing means to determine, at least in part, said frequency selection.

12. A system according to claim 10 or 11, wherein the signal processing apparatus is arranged to process the down converted signal to determine, at least in part, said frequency selection.

## Patentansprüche

1. Signalenergie-Messsystem (100) umfassend einen Aufnahmekopf (110), ein Kabel (114) und eine Signalverarbeitungsvorrichtung (112), wobei der Aufnahmekopf einen Eingang (116) zum Empfang eines zu messenden Testsignals und eine Mischeinrichtung (120) zum Herunterkonvertieren der Frequenz des Testsignals umfasst und das Kabel eingerichtet ist, den Aufnahmekopf mit der Signalverarbeitungsvorrichtung zu verbinden und das herunterkonvertierte Signal vom Aufnahmekopf zur Signalverarbeitungsvorrichtung zu übertragen, und wobei das System **dadurch gekennzeichnet ist, dass**
es weiterhin eine Umwandlungseinrichtung (124) zum Digitalisieren des herunterkonvertierten Signals umfasst und dass die Signalverarbeitungsvorrichtung eingerichtet ist, im digitalen Bereich auf dem digitalisierten, herunterkonvertierten Signal zu arbeiten, um eine Leistungsbestimmung des Testsignals durchzuführen.

2. System nach Anspruch 1, wobei das Kabel eingerichtet ist, mehrere Signale zu übertragen.

3. System nach Anspruch 1 oder 2, wobei das Kabel eingerichtet ist, ein Signal zum Herunterkonvertieren von der Signalverarbeitungsvorrichtung zur Mischeinrichtung zu übertragen, um es zur Herunterkonvertierung der Frequenz des Testsignals mit dem Testsignal zu mischen.

4. System nach Anspruch 1, 2 oder 3, wobei das Kabel eingerichtet ist, eine Energieversorgung in den Aufnahmekopf einzubringen.

5. System nach einem der Ansprüche 1 bis 4, wobei der Aufnahmekopf weiterhin ein Dämpfungsglied (118) zur Reduzierung des Pegels des Testsignals vor dem Mischen umfasst.

6. System nach einem der Ansprüche 1 bis 5, weiterhin umfassend Mittel zur Verstärkung des herunterkonvertierten Signals, um dafür zu sorgen, dass das herunterkonvertierte Signal einen für die Signalverarbeitungsvorrichtung geeigneten Pegel aufweist.

7. System nach Anspruch 6, weiterhin umfassend Mittel zur Regelung der Umgebungsbedingungen um das Verstärkungsmittel herum.

8. System nach einem der Ansprüche 1 bis 7, wobei der Aufnahmekopf weiterhin Mittel zur Regelung der Umgebungsbedingungen um die Mischeinrichtung herum umfasst.

9. System nach einem der Ansprüche 1 bis 8, wobei die Signalverarbeitungsvorrichtung eingerichtet ist, eine Leistungsmessung des Testsignals durchzuführen, die einem ausgewählten CDMA-Code zuordenbar ist.

10. System nach einem der Ansprüche 1 bis 9, wobei die Signalverarbeitungsvorrichtung eingerichtet ist, eine Messung auf einer bestimmten Frequenz oder einem bestimmten Bereich von Frequenzen des Testsignals durchzuführen.

11. System nach Anspruch 10, wobei die Signalverarbeitungsvorrichtung eingerichtet ist, die Mischeinrichtung zu steuern, um die Frequenzauswahl zumindest teilweise zu bestimmen.

12. System nach Anspruch 10 oder 11, wobei die Signalverarbeitungsvorrichtung eingerichtet ist, das herunterkonvertierte Signal zu verarbeiten, um die Frequenzauswahl zumindest teilweise zu bestimmen.

## Revendications

1. Système de mesure de puissance de signal (100) comprenant une tête de détecteur (110), un câble (114) et un appareil de traitement de signal (112), dans lequel la tête de détecteur comprend une entrée (116) pour recevoir un signal de test à mesurer et des moyens de mixage (120) pour abaisser en fréquence le signal de test, et le câble est agencé pour connecter la tête de détecteur à l'appareil de traitement de signal et pour transmettre le signal abaissé de la tête de détecteur à l'appareil de traitement de signal, et le système est **caractérisé en ce qu'**il comprend en outre des moyens de conversion (124) pour numériser le signal abaissé et **en ce que** l'appareil de traitement de signal est agencé pour agir sur le signal numérisé abaissé dans le domaine numérique pour exécuter une mesure de puissance sur le signal de test.

2. Système selon la revendication 1, dans lequel le câble est agencé pour transmettre des signaux multiples.

3. Système selon la revendication 1 ou 2, dans lequel le câble est agencé pour amener un signal abaisseur aux moyens de mixage à partir de l'appareil de traitement de signal pour mixage avec le signal de test pour abaisser en fréquence le signal de test.

4. Système selon la revendication 1, 2 ou 3, dans lequel le câble est agencé pour apporter une alimentation électrique dans la tête de détecteur.

5. Système selon l'un quelconque des revendications 1 à 4, dans lequel la tête de détecteur comprend en outre un atténuateur (118) pour réduire le niveau du signal de test avant mixage.

6. Système selon l'une quelconque des revendications 1 à 5, comprenant en outre des moyens pour amplifier le signal abaissé pour faire en sorte que le signal abaissé ait un niveau approprié pour l'appareil de traitement de signal.

7. Système selon la revendication 6, comprenant en outre des moyens pour commander les conditions environnementales autour des moyens d'amplification.

8. Système selon l'une quelconque des revendications 1 à 7, dans lequel la tête de détecteur comprend en outre des moyens pour commander les conditions environnementales autour des moyens de mixage.

9. Système selon l'une quelconque des revendications 1 à 8, dans lequel l'appareil de traitement de signal est agencé pour exécuter une mesure de la puissance dans le signal de test attribuable à un code AMRC choisi.

10. Système selon l'une quelconque des revendications 1 à 9, dans lequel l'appareil de traitement de signal est agencé pour exécuter une mesure sur une fréquence choisie ou une gamme choisie de fréquences à partir du signal de test.

11. Système selon la revendication 10, dans lequel l'appareil de traitement de signal est agencé pour commander les moyens de mixage pour déterminer, au moins en partie, ledit choix de fréquence.

12. Système selon la revendication 10 ou 11, dans lequel l'appareil de traitement de signal est agencé pour traiter le signal abaissé pour déterminer, au moins en partie, ledit choix de fréquence.
